# EUROPEAN PATENT SPECIFICATION

(11) **EP 1 535 866 B1**
(45) Date of publication and mention of the grant of the patent: **28.07.2010**
(21) Application number: 03733178.2
(22) Date of filing: 29.05.2003
(51) Int. Cl.: B65G 27/24

(54) **STRAIGHT FORWARD MOVING PARTS FEEDER**
ZUFUHRVORRICHTUNG ZUR GERADEAUSBEWEGUNG VON TEILEN
DISPOSITIF D'ALIMENTATION DE PIECES SE DEPLACANT VERS L'AVANT

(30) Priority: 22.08.2002 JP 2002241912
(43) Date of publication of application: 01.06.2005
(73) Proprietor: Sanki Co., Ltd., Nagoya-shi, Aichi 455-0021 (JP)
(72) Inventor: NAKAYAMA, Kou, Chigasaki-shi, Kanagawa 253-0082 (JP); NISHIKAWA, Takuya, Kuwana-shi, Mie 511-0002 (JP); NAKAYAMA, Hiroshi, Kawagoe-shi, Saitama 350-0027 (JP)
(74) Representative: Faraggiana, Vittorio
(86) International application number: PCT/JP2003/006786
(87) International publication number: WO 2004/018329

(56) References cited:
- JP-A- 06 345 238
- JP-A- 10 175 724
- JP-B2- 2 897 894

## Description

### TECHNICAL FIELD

This invention relates to an in-line parts feeder which transports relatively smaller articles such as electric elements or mechanical components by vibration excited by piezoelectric vibration generating means.

### BACKGROUND ART

Parts feeders having piezoelectric elements as a driving source have conventionally been used to transport relatively smaller parts such as chip resistors or chip capacitors. Since these parts are oriented in many cases, used parts feeders transport objects (works) while lining up them in a given direction such as a vertical direction or horizontal direction. These parts feeders are provided with a supply feeding path and a recovery feeding path both of which are adjacent to each other. Some of works transported along the supply feeding path differ from the other works in the line-up direction and are moved to the recovery feeding path.

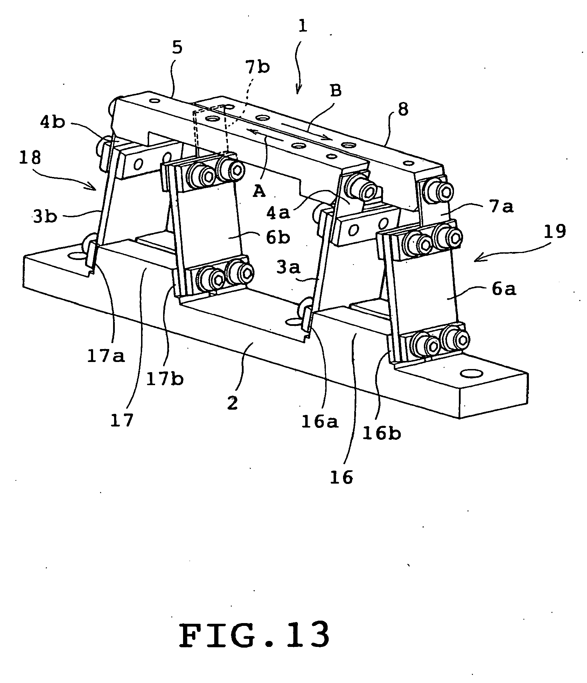

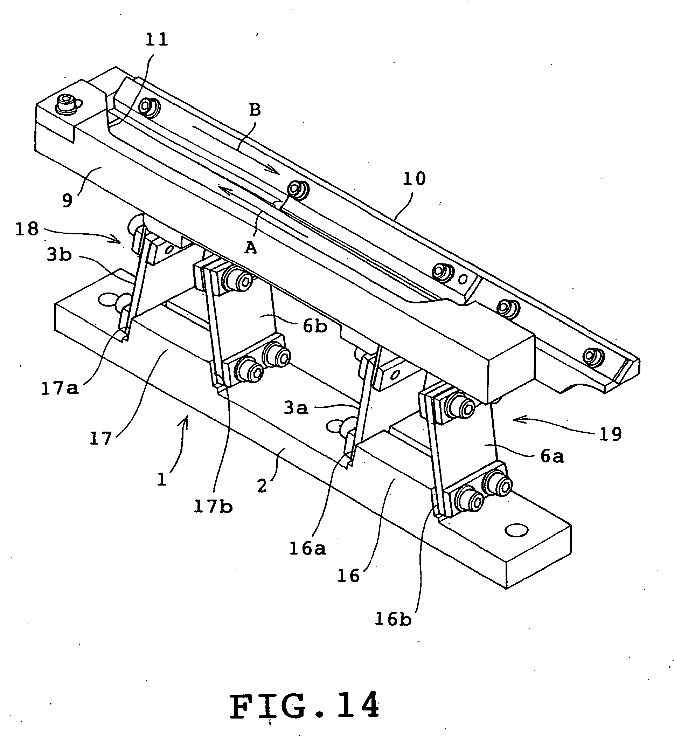

The conventional construction of the parts feeder provided with two feeding paths will be described with reference to FIGS. 13 and 14. The parts feeder 1 comprises a base plate 2 installed and fixed to an installation side (not shown) and first and second top plates 5 and 8 connected via first and second vibration exciting means 18 and 19 to the base plate 2 respectively.

Substantially trapezoidal convex portions 16 and 17 are provided on the front and rear (left and right as viewed in FIG. 13) of the base plate 2 respectively. The convex portions 16 and 17 have rear inclined faces 16a and 17a respectively. Lower portions of piezoelectric vibrators 3a and 3b are screwed on the inclined faces 16a and 17a respectively. Each of the piezoelectric vibrators 3a and 3b comprises an elastic metal plate (for example, metal shim plate) having both sides to which piezoelectric elements are bonded respectively.

Vibration amplifying leaf springs 4a and 4b are screwed on upper portions of the piezoelectric vibrators 3a and 3b respectively. The leaf springs 4a and 4b are fixed to the upper front portions of the piezoelectric vibrators 3a and 3b respectively as viewed in FIG. 13. The first top plate 5 is connected to the upper portions of the leaf springs 4a and 4b. As the result of the above-described construction, the top plate 5 is connected to the base plate 2 so as to be inclined frontward (rightward as viewed in FIG. 13). The piezoelectric vibrators 3a and 3b and leaf springs 4a and 4b constitute vibration exciting means 18.

On the other hand, the vibration exciting means 19 comprises piezoelectric vibrators 6a and 6b fixed to front inclined faces 16b and 17b of the convex portions 16 and 17, and leaf springs 7a and 7b fixed to upper portions of the piezoelectric vibrators 6a and 6b, respectively. The leaf springs 7a and 7b are fixed to the upper front portions of the piezoelectric vibrators 6a and 6b respectively as viewed in FIG. 13. A second top plate 8 is connected to upper portions of the leaf springs 7a and 7b respectively. As the result of the above-described construction, the top plate 8 is connected to the base plate 2 so as to be inclined rearward (leftward as viewed in FIG. 13).

First and second chutes 9 and 10 are fixed to upper sides of the top plates 5 and 8 respectively. The first and second chutes 9 and 10 are provided with a recovery feeding path 9a and a supply feeding path 10a respectively.

When AC voltage is applied to the piezoelectric vibrators 3a and 3b in the parts feeder 1, vibration is excited in the top plate 5 and chute 9 such that works (not shown) on the recovery feeding path 9a are transported in the direction of arrow A. On the other hand, when AC voltage is applied to the piezoelectric vibrators 6a and 6b, vibration is excited in the top plate 8 and chute 10 such that works (not shown) on the supply feeding path 10a are transported in the direction of arrow B.

The supply feeding path 10a is provided with a position sensor, work selecting means, means for moving differently directed works to the recovery feeding path 9a and the like. Further, a direction changing portion comprising an inclined wall is provided on a termination of the recovery feeding path 9a so that works having been moved from the supply feeding path 10a to the recovery feeding path 9a are returned to a start of the supply feeding path 10a.

Of works in movement in the direction of arrow B along the supply feeding path 10a, one or those which are in correct posture are transported ahead to a production line. Works in incorrect posture are moved to the recovery feeding path 9a. When moved to the recovery feeding path 9a, reaching the termination of the recovery feeding path 9a, works are returned to the start of the supply feeding path 10a to be re-transported along the supply feeding path 10a in the direction of arrow B. Thus, the parts feeder 1 has a bidirectionally transporting function of transporting works in both directions of arrows A and B.

However, the first and second vibration exciting means 18 and 19 are constructed independently of each other in the foregoing parts feeder 1. In other words, the parts feeder 1 is constructed by combining two parts feeders each of which transports works in one direction. This results in a problem that the number of components and the number of assembling steps are large.

When the number of assembling steps is large, an error is easy to occur in the assembly. As a result, even when the piezoelectric vibrators 3a, 3b, 6a and 6b of the vibration exciting means 18 and 19 have the same specifications, the same vibration characteristic cannot be achieved in many cases, whereupon control of the whole parts feeder becomes difficult.

Further, mounting positions of the piezoelectric vibrators 3a, 3b, 6a and 6b on the base plate 2 are shifted in the transporting direction so that the size of the parts feeder 1 is reduced. However, this requires the provision of the inclined faces 16a, 16b, 17a and 17b on which the piezoelectric vibrators 3a, 3b, 6a and 6b are mounted, whereupon the construction of the base plate 2 is complicated.

On the other hand, the applicant owns a patent granted on the invention of an upright parts feeder (Japanese Patent No. 2897894). In this parts feeder, piezoelectric vibrators and leaf springs are disposed so as to stand upright substantially perpendicularly to a base plate. Accordingly, since no adjustment is required of inclinations of the piezoelectric vibrators and leaf springs, a speed at which works are transported can easily be adjusted. Further, the size of the parts feeder can be reduced since the piezoelectric vibrators and leaf springs are not inclined.

Thus, the construction of the upright parts feeder can be employed in the parts feeder with a bidirectional transportation function, whereupon a size reduction can be achieved. However, the problem of a large number of components and a large number of assembling steps cannot be overcome even when the construction of the upright parts feeder is just employed.

An object of the present invention is to provide an in-line parts feeder which can reduce the number of components and the number of assembling steps and improve the assembling accuracy.

### DISCLOSURE OF THE INVENTION

The present invention is an in-line parts feeder which comprises a base plate and a plurality of top plates connected via vibration exciting means to an upper face of the base plate and in which the top plates are vibrated by the vibration exciting means so that articles are transported, characterized in that the vibration exciting means comprises a pair of piezoelectric vibrators fixed to the base plate and a plurality of pairs of spring members each having an upper end connected to both ends of the top plates with respect to a transporting direction of each top plate and a lower end connected to upper ends of the paired piezoelectric vibrators.

According to the above-described construction, since the paired piezoelectric vibrators applying vibration to a plurality of top plates are common to a plurality of the top plates, the number of components and the number of assembling steps can be reduced as compared with the conventional parts feeders. Further, since the paired piezoelectric vibrators are just fixed to the base plate, the construction of the connecting portion between the base plate and the piezoelectric vibrators can be simplified.

In this case, it is preferable that the piezoelectric vibrators and the spring members are disposed so as to be substantially perpendicular to the base plate, and each spacer defines a horizontal space between each piezoelectric vibrator and the corresponding spring member.

According to the above-described construction, a mounting space used to mount the piezoelectric vibrators on the base plate can be reduced. Further, a thickness of each spacer is adjusted to a suitable value so that inclinations of the top plates relative to the base plate are adjusted, whereby a transporting speed of the objects can be adjusted.

### BRIEF DESCRIPTION OF THE DRAWINGS

FIG. 1 is a perspective view of the parts feeder in accordance with a first embodiment of the present invention with the chute being removed;
FIG. 2 is a front view of the parts feeder with the chute being removed;
FIG. 3 is a right side view of a front of the parts feeder with the chute being removed;
FIG. 4 is an exploded perspective view of one of the vibration exciting means;
FIG. 5 is an exploded perspective view of the connecting portion between the piezoelectric elements and a spacer;
FIG. 6 is a perspective view of the whole parts feeder;
FIG. 7 is a plan view of the parts feeder, explaining transportation of works while the works are being lined up;
FIG. 8A is a sectional view taken along line 8A-8A in FIG. 7;
FIG. 8B is a sectional view taken along line 8B-8B in FIG. 7;
FIG. 9 is a perspective view explaining transportation of works while the works are being lined up;
FIG. 10 is an enlarged view of a part C in FIG. 9;
FIG. 11 is a view similar to FIG. 1, showing a second embodiment of the present invention;
FIG. 12 is a view similar to FIG. 5;
FIG. 13 is a view similar to FIG. 1, showing a prior art example; and
FIG. 14 is a view similar to FIG. 6.

### BEST MODE FOR CARRYING OUT THE INVENTION

The present invention will be described in detail with reference to the accompanying drawings.

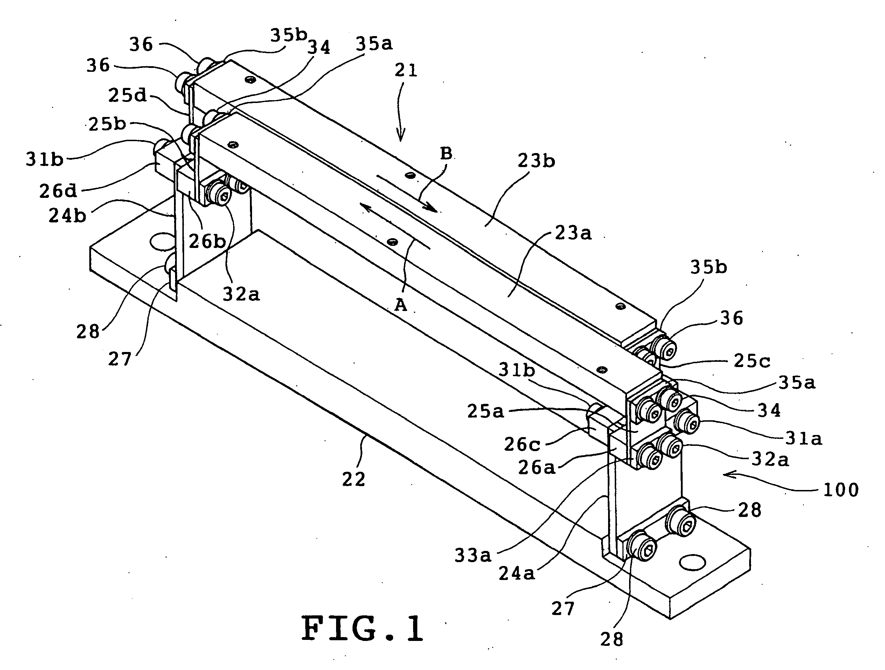

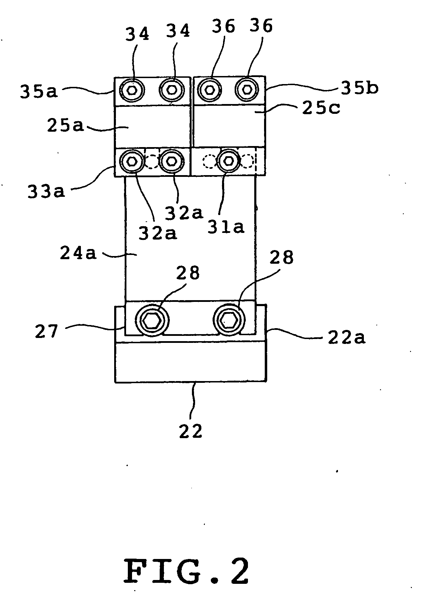

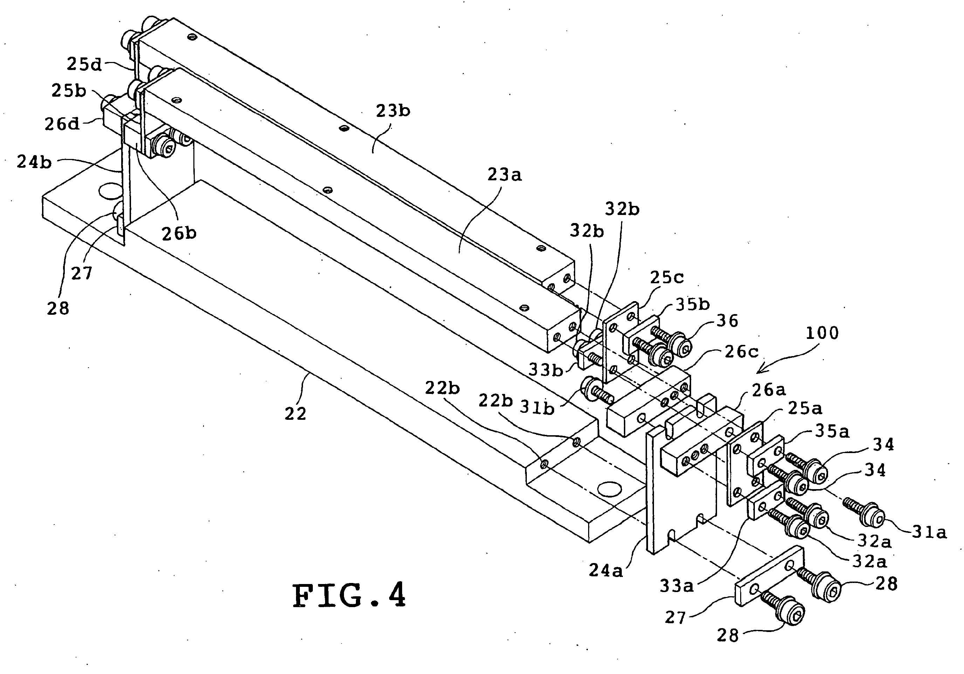

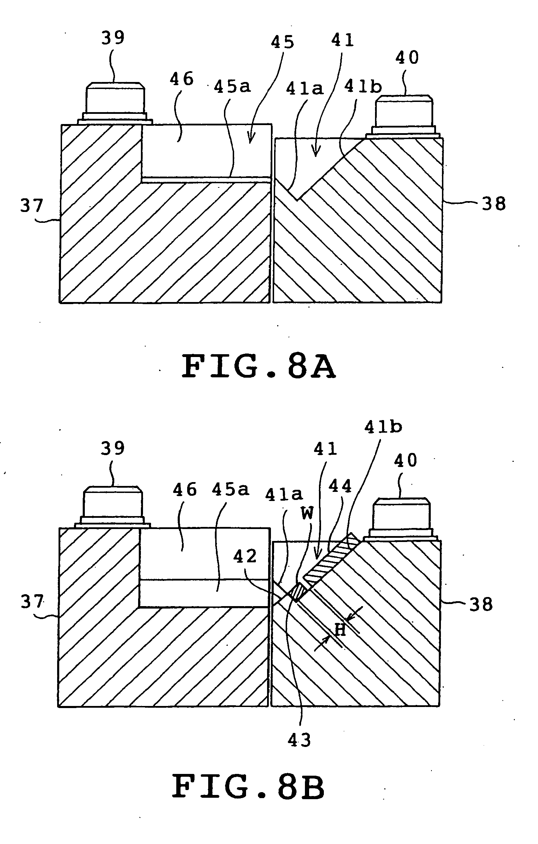

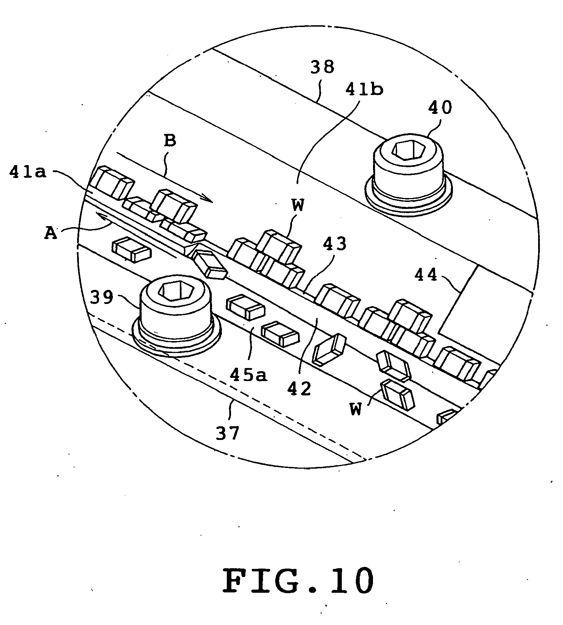

FIGS. 1 to 10 illustrate a first embodiment of the invention. Referring first to FIGS. 1 to 6, the construction of the parts feeder 21 in accordance with the invention will be described. The parts feeder 21 comprises a base plate 22, first and second top plates 23a and 23b connected via vibration exciting means 100 to the base plate 22, and first and second chutes 37 and 38 attached to the first and second top plates 23a and 23b respectively.

The vibration exciting means 100 comprises a pair of piezoelectric vibrators 24a and 24b fixed to an upper side of the base plate 22, a pair of spacers 26a and 26b and a pair of leaf springs (corresponding to spring members) 25a and 25b connecting upper ends of the piezoelectric vibrators 24a and 24b and the first top plate 23a, and a pair of spacers 26c and 26d and a pair of leaf springs (corresponding to spring members) 25a and 25d.

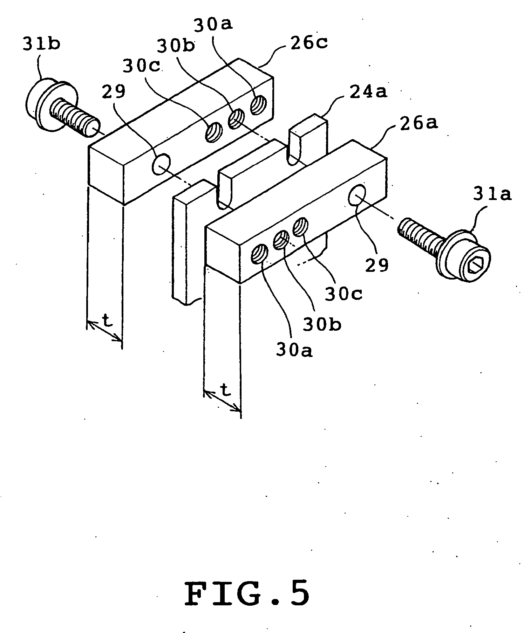

Each of the spacers 26a to 26d is made of a metal and formed into a rectangular parallelepiped whose thickness is set at t (see FIG. 5). Each of the spacers 26a to 26d has a width set to be approximately equal to each of the piezoelectric vibrators 24a and 24b. Each of the spacers 26a to 26d has a through hole 29 and three screw holes 30a to 30c (see FIG. 5).

The leaf springs 25a to 25d are provided for vibratory amplification and have the same specification. Each of the leaf springs 25a to 25d is formed into the shape of a rectangular plate having a width which is about one half of a width of each of the spacers 26a to 26d.

The base plate 22 is fixed to a mounting face while being grounded. A mount 22a is provided on a central upper side of the base plate 22. The mount 22a has vertical front and rear faces (left and right sides as viewed in FIG. 1). Piezoelectric vibrators 24a and 24b are fixed on the front and rear faces respectively. Each of the piezoelectric vibrators 24a and 24b comprises two piezoelectric ceramic plates having electrodes on both sides and an elastic metal plate, for example, a metal shim plate having both sides to which the piezoelectric ceramic plates are bonded, respectively, as well known in the art.

The vibration exciting means 100 connected to the front and rear faces of the mount 22a have the same connecting structure. Accordingly, the following describes the mounting structure of the vibration exciting means 100 connected to the front face (the right side as viewed in FIG. 1) of the mount 22a.

The front of the mount 22a is formed with two screw holes 22b extending perpendicularly thereto. A lower end of the piezoelectric vibrator 24a is held between the front of the mount 22a and a seat 27, and screws 28 are screwed into the screw holes 22b, whereby the piezoelectric vibrator 24a is mounted on the front of the mount 22 so as to stand perpendicularly to the upper surface of the base plate 24a.

The leaf spring 25a is connected via the spacer 26a to a front upper end of the piezoelectric vibrator 24a. Further, the leaf spring 25c is connected via the spacer 26c to a rear upper end of the piezoelectric vibrator 24a.

The spacer 26a is disposed so that the through hole 29 is located in front on the right of the piezoelectric vibrator 24a, while the spacer 26c is disposed so that the through hole is located rearward on the left of the piezoelectric vibrator 24a. As a result, the through hole 29and screw hole 30b of the spacer 26a are opposed to the screw hole 30b and through hole 29 of the spacer 24c with the piezoelectric vibrator 24a being held therebetween.

In this state, a screw 31a is inserted through the through hole 29 of the spacer 26a and the groove of the piezoelectric vibrator 24a into the screw hole 30b of the spacer 26c to be tightened up. Further, a screw 31b is inserted through the through hole 29 of the spacer 26c and the groove of the piezoelectric vibrator 24a into the screw hole 30b of the spacer 26a to be tightened up. As a result, the spacers 26a and 26c are fixed while the piezoelectric vibrator 24a is held therebetween.

The lower end of the leaf spring 25a is abutted against the front of the spacer 26a fixed as described above, and two screws 32a are inserted through a spacer 33a into the other screw holes 30a and 30c of the spacer 26a to be tightened up, respectively. Consequently, the leaf springs 25a and 25c are connected to the front and rear upper ends of the piezoelectric vibrator 24a with a distance the piezoelectric vibrator 24a and each of the leaf springs 25a and 25c. Since the spacers 26a and 26c are each formed into a rectangular parallelepiped, the leaf springs 25a and 25c are disposed so as to be substantially in parallel to the piezoelectric vibrator 24a and so as to be substantially perpendicular to the upper side of the base plate 22. As the result of the above-described construction, the leaf springs 25a and 25c are connected to the piezoelectric vibrator 24a so as to be displaced from the piezoelectric vibrator 24a left and right and further back and forth.

On the other hand, the front ends of the first and second top plates 23a and 23b are perpendicular to the upper sides of the top plates 23a and 23b. The upper end of the leaf spring 25a is then fixed via a spacer 35a and screw 34 to the front of the first top plate 23a. Further, the upper end of the leaf spring 25c is then fixed via a spacer 35b and screw 36 to the front of the second top plate 23b.

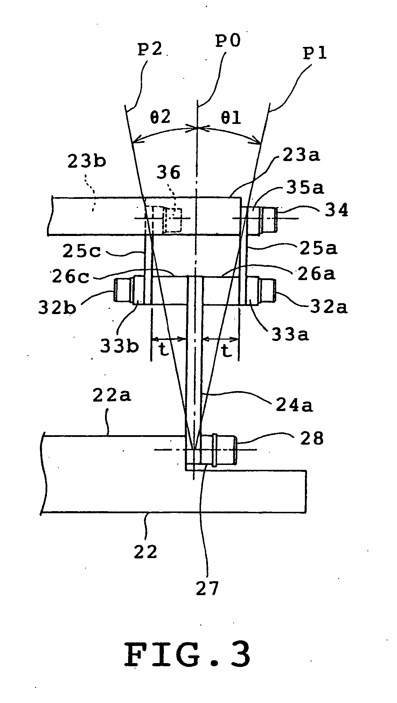

As the result of the above-described construction, a plane P1 passes the connection of the first top plate 23a and leaf spring 25a and the connection of the piezoelectric vibrator 24a and base plate 22 as shown in FIG. 3 which is a right side view of the front portion of the parts feeder 21. The plane P1 is inclined by an angle θ1 frontward relative to a plane P0 perpendicular to the upper side of the base plate 22 (vertical plane) Further, a plane P2 passes the connection of the second top plate 23b and leaf spring 25c and the connection of the piezoelectric vibrator 24a and base plate 22. The plane P2 is inclined by an angle θ2 rearward relative to the vertical plane P0.

The inclinations θ1 and θ2 depend upon the thicknesses of the spacers 26a and 26b and the lengths of the piezoelectric vibrator 24a and leaf springs 25a and 25b and the like. Since the spacers 26a and 26c have the same shape and the leaf springs 25a and 25c have the same shape in the embodiment, the inclinations θ1 and θ2 are equal to each other. Also, inclinations have the similar relationship in the rear of the parts feeder 21 although the relationship is not shown.

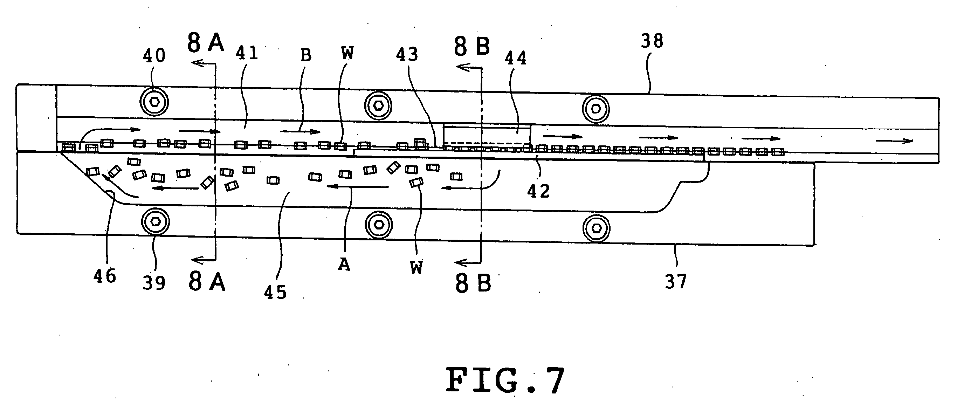

When AC voltage is applied to the piezoelectric elements constituting the piezoelectric vibrators 24a and 24b of the parts feeder 21 so that vibration is excited, the vibration is amplified by each of the leaf springs 25a to 25d to be transmitted to the first and second top plates 23a and 23b. In this case, the first top plate 23a produces such vibration that works W (see FIG. 7) serving as objects are moved in the direction of arrow A in FIG. 1, whereas the second top plate 23b produces such vibration that works W are moved in the direction of arrow B (opposite direction to the arrow A). Thus, the parts feeder 21 has a bidirectional feeding function of feeding works W normal and reverse directions at the same speed.

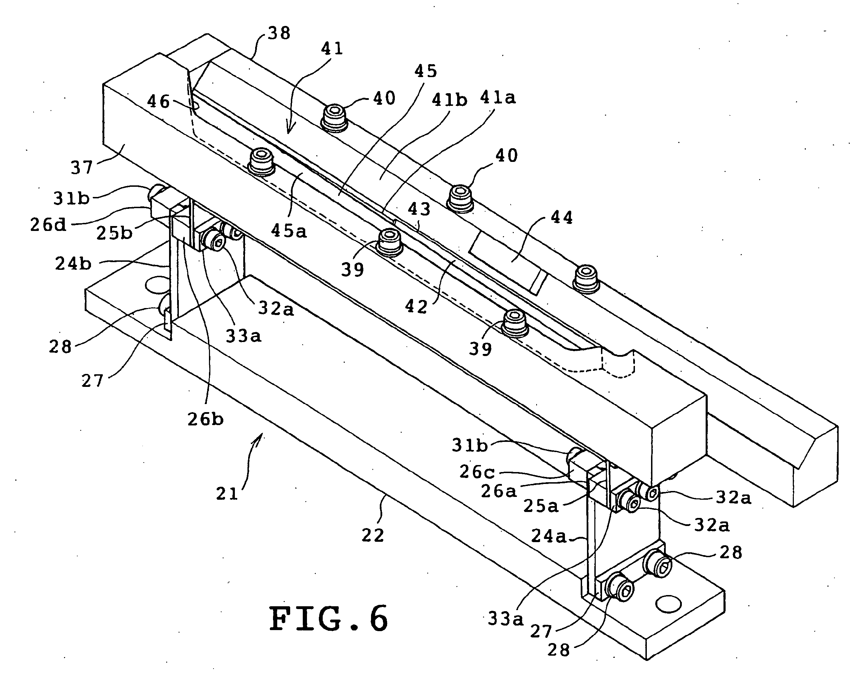

The construction of the first and second chutes 37 and 38 will now be described with reference to FIGS. 6 to 10. The first chute 37 is fixed to the upper side of the first top plate 23a by screws 39. Further, the second chute 38 is fixed to the upper side of the second top plate 23b by screws 40. The first top plate 23a has a truck 45 serving as the recovery feeding path, whereas the second top plate 23b has a truck 41 serving as the supply feeding path. The second top plate 23b has a larger length than the first top plate 23a. The truck 45 of the first chute 37 has a bottom 45a inclined from the front toward the rear. The truck 45 has an open portion facing the second chute 38. The truck 41 of the second chute 38 has a bottom including V-shaped inclined faces 41a and 41b. The inclined face 41a adjacent to the first chute 37 has a width smaller than the incline face 41b.

The inclined face 41a has in a lengthwise middle thereof a notch 42 which is inclined toward and continuous to the bottom 45a of the truck 45. Accordingly, the portion of the inclined face 41a where the notch 42 is formed serves as a narrow portion 43 having a smaller width than the other portion of the inclined face 41a. As the result of the above-described construction, the bottom 45a of the truck 45 has a rear end which is located slightly higher than the inclined face 41a of the truck 41. The bottom 45a further has a portion which corresponds to the notch 42 and is continuous to the notch 42 or is located lower than the notch 42. The bottom 45a still further has a portion which is between the rear end and notch 42 and is located lower than the inclined face 41a.

On the other hand, a rectangular plate-shaped limiting member 44 is provided on the portion of the inclined face 41b corresponding to the narrow portion 43. The limiting member 44 is located higher than the narrow portion 43 by distance H. The distance H and the width of the narrow portion 43 are set according to the shape and size of the work W. Further, a direction changing portion 46 is provided on the rear end of the truck 45 and comprises an inclined wall for moving the works W on the bottom 45a to the truck 41.

The operation of the foregoing construction will now be described with reference to FIGS. 7 to 10. In the following exemplified case, the works W comprise flat rectangular box-shaped chip capacitors and are transported while being lined up in a transversely disposed state. Accordingly, distance H between the limiting member 44 and the narrow portion 43 is set so as to be substantially equal to the width of the chip capacitor, and the narrow portion 43 has a width set so as to be substantially equal to the thickness of the chip capacitor.

When AC voltage is applied to the piezoelectric vibrators 24a and 24b so that vibration is excited, the first and second chutes 37 and 38 are vibrated with the first and second top plates 23a and 23b. As a result, the works W supplied to the truck 41 of the second chute 38 from the supply mechanism (not shown) are transported in the direction of arrow B on the truck 41. Some of the works W having reached the narrow portion 43 and overflowing the narrow portion 43 are caused to slide through the notch 42 into the truck 45 of the first chute 37. Further, the works W blocked by the limiting member 44, which include those stacked in two layers, reached the narrow portion 43 in a longitudinally disposed state or the like, are also caused to slide through the notch 42 into the truck 45.

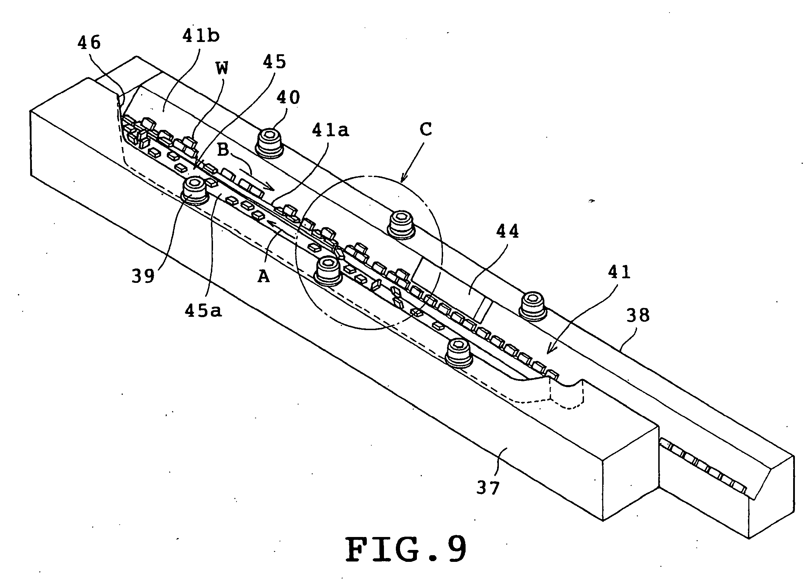

Consequently, the works W transported through the narrow portion 43 to the termination of the truck 41 are lined up (transversely disposed state as shown in FIGS. 7 and 9). Thus, the narrow portion 43 and limiting member 44 serve as work selecting means for determining directivity of the works W. The parts feeder 21 is further provided with a position sensor, a pneumatic mechanism for eliminating the works W (moving them for recovery) and the like as the work selecting means, whereupon the works can reliably be selected.

On the other hand, the works W having slid into the truck 45 of the first chute 37 are moved along the bottom 45a of the truck 45 in the direction of arrow A and the direction of the works W is changed at the direction changing portion 46 thereby to be returned to the truck 41. The returned works W are selected by the narrow portion 43, limiting member 44 and the like together with newly supplied works W, being transported forward in the lined state.

As described above, the vibration applying piezoelectric vibrators 24a and 24b are common to the first and second top plates 23a and 23b in the parts feeder 21 of the embodiment. More specifically, to the paired piezoelectric vibrators 24a and 24b are connected the leaf springs 25a and 25b for the top plate 23a, spacers 26a and 26b, the leaf springs 25c and 25d for the second top plate 23b, and spacers 26c and 26d.

Consequently, the paired piezoelectric vibrators 24a and 24b can apply vibration to the plural top plates 23a and 23b and the number of components and the number of assembly can be reduced as compared with the conventional parts feeders. In particular, since the only requirement is to fix the paired piezoelectric vibrators 24a and 24b to the base plate 22, the construction for connecting the base plate 22 and piezoelectric vibrators 24a and 24b can be simplified. Since the number of assembly steps is smaller, the number of errors in assembly can be reduced, whereupon the accuracy in the assembly can be improved. Further, the driving control can be simplified since the piezoelectric vibrators 24a and 24b are in common to the top plates 23a and 23b. Consequently, the drive control can be simplified and the maintenance of the parts feeder can be rendered easier.

Further, the piezoelectric vibrators 24a and 24b are fixed to the base plate 22 so as to be substantially perpendicular to the base plate 22. Consequently, the number of errors in assembly can be rendered smaller as compared with the construction in which a piezoelectric element is fixed to a base plate so as to be inclined. Further, since the piezoelectric vibrators 24a and 24b are connected to the base plate 22 so as to stand upright, a space used for mounting the piezoelectric vibrators 24a and 24b on the base plate 22 can be rendered smaller.

The leaf springs 25a to 25d are mounted via the spacers 26a to 26d to the piezoelectric vibrators 24a and 24b respectively in the foregoing embodiment. Accordingly, when the thicknesses of the spacers 26a to 26d are adjusted or the number of spacers is adjusted, the inclinations θ1 and θ2 of the top plates 23a and 23b relative to the base plate 22 can readily be adjusted. A works transporting speed can be adjusted by the adjustment of the inclinations of θ1 and θ2. In this connection, when the shapes and specifications of the spacers 26a to 26d and the leaf springs 25a to 25d are just equalized, as described above, the works transporting speeds can become constant on the trucks 41 and 45.

The leaf springs for the first and second top plates 23a and 23b are disposed back and forth relative to the piezoelectric vibrators 24a and 24b in the foregoing embodiment. Accordingly, the works on the first and second top plates 23a and 23b are transported in the opposite directions. On the other hand, the works can be transported on the first and second top plates 23a and 23b in the same direction when the leaf springs for the first and second top plates 23a and 23b are disposed at the same positions which are the front or rear of the piezoelectric vibrators 23a and 23b.

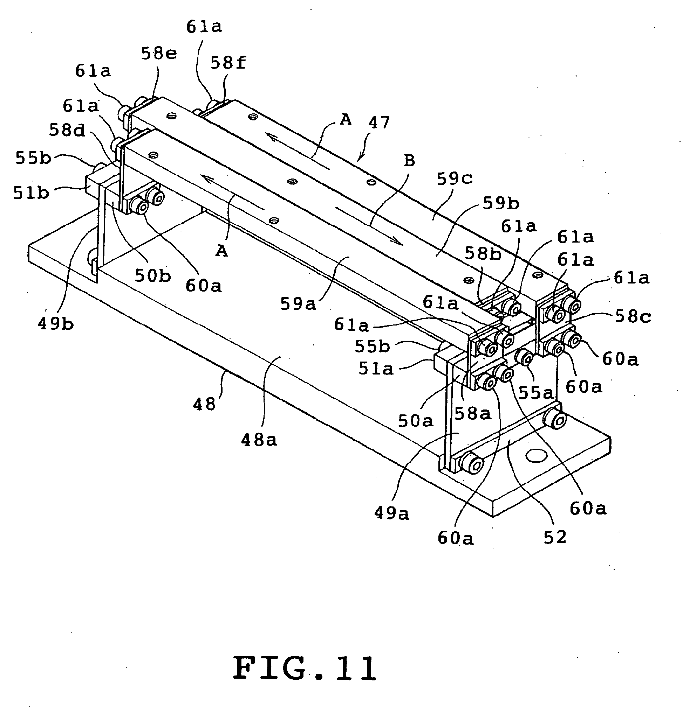

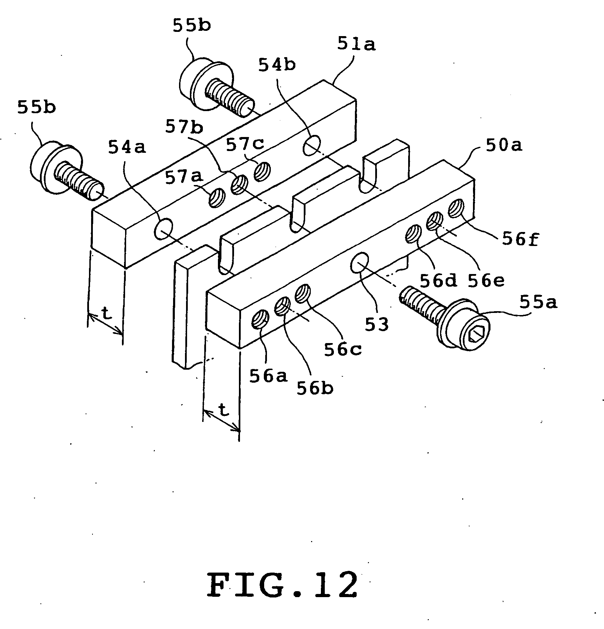

FIGS. 11 and 12 illustrate a second embodiment of the present invention. Only the difference of the second embodiment from the first embodiment will be described. The identical or similar parts are labeled by the same reference symbols as those in the first embodiment. The parts feeder 47 of the second embodiment differs from the first embodiment in that three feeding paths are provided. More specifically, a mount 48a is formed on the upper side of the base plate 48. The mount 48a has vertical front and rear faces on which the piezoelectric vibrators 49a and 49b are screwed via the spacer 52 respectively.

The leaf springs 58a to 58c are connected via the spacers 50a and 51a to an upper end of the piezoelectric vibrator 49a. On the other hand, the leaf springs 58d to 58f are connected via the spacers 50b and 51b to the upper end of the piezoelectric vibrator 49b. The spacers 50a, 50b, 51a and 51b have the same shape and respective thicknesses set at t.

The first top plate 59a is fixed by screws 61a between the leaf springs 58a and 58d. The second top plate 59b is fixed by screws 61a between the leaf springs 58b and 58e. A third top plate 59c is fixed by screws 61a between the leaf springs 58c and 58f. The spacer 50a has a centrally formed through hole 53 and the screw holes 56a to 56c and screw holes 56d to 56f in right and left portions thereof respectively. On the other hand, the spacer 50b has through holes 54a and 54b in the left and right portions thereof and centrally formed screw holes 57a to 57c. The spacers 50a and 51a are applied to the front and rear upper end portions of the piezoelectric vibrator 49a respectively, and screws 55a and 55b are screwed through the through holes 53, 54a and 54b into the screw holes 57b, 56b and 56e respectively thereby to be fixed to the piezoelectric vibrator 49a.

The leaf springs 58a and 58c are fixed to the left and right portions of the spacer 50a by screws 60a respectively. Further, the leaf spring 58b is fixed to the central portion of the spacer 51a by the screw 60a. In this case, each of the leaf springs 58a to 58c has a width set to be about one third of the width of the piezoelectric vibrator 49a. Also, in this embodiment, the leaf springs 58a to 58c are disposed so as to be perpendicular to the base plate 48. The second embodiment is the same as the first embodiment in the construction for connecting the piezoelectric vibrator 49b and each of the spacers 50b and 51b and the construction for connecting the spacers 50b and 51b and the leaf springs 58d to 58f, and accordingly, the description of the constructions is eliminated.

Upon excitation of vibration by application of voltage to the piezoelectric vibrators 49a and 49b, the vibration is applied to the first and third top plates 59a and 59c so that the works are transported in the direction of arrow A, whereas the vibration is applied to the second top plate 59b so that the works are transported in the direction of arrow B. Thus, the parts feeder 47 of the embodiment has two feeding paths with the same direction of transportation and a single feeding path with the direction of transportation opposed to that of the two feeding paths, that is, the parts feeder has a function of bidirectional transportation and a function of multi-row transportation. Since the paired piezoelectric vibrators 49a and 49b apply vibration to the three top plates 59a, 59b and 59c, the parts feeder can be rendered smaller in size. Thus, the same effect can be achieved from the second embodiment as from the first embodiment.

The present invention should not be limited to the foregoing embodiments but may be modified as follows. The shape of each spacer should not be limited to the rectangular parallelepiped. Each spacer may be formed into a cranked shape or C-shape. Further, a plurality of washers may be stacked into a spacer. Each spring member may be of a curved shape or a bar shape other than the rectangular plate shape.

The piezoelectric vibrators and spring members may be disposed so as to be inclined relative to the base plate. In this case, the spacers provided between the piezoelectric vibrators and spring members may be eliminated. The direction of works may be determined by detecting means such as a photo sensor, instead of the limiting member 44.

A plurality of feeding paths or two groups of paths are opposed to each other in the direction of transportation in the foregoing embodiments. However, a plurality of feeding paths may have the same direction of transportation. Although the top plates are vibrated by the paired piezoelectric vibrators in the foregoing embodiments, one of the piezoelectric vibrators may be an elastic plate. More specifically, piezoelectric elements are bonded to both sides of one of two elastic plates and no piezoelectric elements are bonded to the other elastic plate. In this case, too, the top plates can be vibrated so that objects are transported.

### INDUSTRIAL APPLICABILITY

As described above, the in-line parts feeder in accordance with the present invention is useful as a feeding path realizing multi-row transportation which transports objects along multiple of rows of paths. In particular, the in-line parts feeder can be suitably applied to a case where the parts feeder has a supply feeding path along which objects are transported while the objects are lined up and a recovery feeding path which recovers objects eliminated from the supply feeding path, both paths being adjacent to each other.

## Claims

1. An in-line parts feeder (21; 47) which comprises a base plate (22; 48) and a plurality of top plates (23a, 23b; 59a, 59b, 59c) connected via vibration exciting means (100) to an upper face of the base plate (22; 48) and in which the top plates (23a, 23b; 59a, 59b, 59c) are vibrated by the vibration exciting means (100) so that objects are transported, **characterized in that** the vibration exciting means (100) comprises a pair of piezoelectric vibrators (24a, 24b; 49a, 49b) fixed to the base plate (22; 48) and a plurality of pairs of spring members (25a-25d; 58a-58f) each having an upper end connected to both ends of the top plates (23a, 23b; 59a, 59b, 59c) with respect to a transporting direction of each top plate and a lower end connected to upper ends of the paired piezoelectric vibrators (24a, 24b; 49a, 49b).

2. The in-line parts feeder according to claim 1, **characterized in that** the piezoelectric vibrators (24a, 24b; 49a, 49b) and the spring members (25a-25d; 58a-58f) are connected via spacers (26a-26d; 50a, 50b, 51a, 51b) to each other respectively.

3. The in-line parts feeder according to claim 2, **characterized in that** the piezoelectric vibrators (24a, 24b; 49a, 49b) and the spring members (25a-25d; 58a-58f) are disposed so as to be substantially perpendicular to the base plate (22; 48), and each spacer (26a-26d; 50a, 50b, 51a, 51b) defines a horizontal space between each piezoelectric vibrator and the corresponding spring member.

4. The in-line parts feeder according to claim 3, **characterized in that** the spring members (25a-25d; 58a-58f) connected to one or more of the top plates (23a, 23b; 59a, 59b, 59c) are connected via the spacers (26a-26d; 50a, 50b, 51a, 51b) to one of both sides of each piezoelectric vibrator (24a, 24b; 49a, 49b), and the spring members (25a-25d; 58a-58f) connected to the other top plate or other top plates (23a, 23b; 59a, 59b, 59c) are connected via the spacers (26a-26d; 50a, 50b, 51a, 51b) to the other side of each piezoelectric vibrator (24a, 24b; 49a, 49b).

5. The in-line parts feeder according to claim 1, **characterized in that** the vibration exciting means (100) is constructed so that a transporting direction of one or more of the top plates (23a, 23b; 59a, 59b, 59c) differ from a transporting direction of the other top plate.

6. An in-line parts feeder (21; 47) which comprises a base plate (22; 48) and a plurality of top plates (23a, 23b; 59a, 59b, 59c) connected via vibration exciting means (100) to an upper face of the base plate (22; 48) and in which the top plates (23a, 23b; 59a, 59b, 59c) are vibrated by the vibration exciting means (100) so that articles are transported, **characterized in that** the vibration exciting means (100) includes a pair of elastic plates fixed to the base plate (22; 48), piezoelectric elements joined to both sides of at least one of the paired elastic plates, and a plurality of pairs of spring members (25a-25d; 58a-58f) having upper ends connected to both ends of the top plates with respect to a transporting direction of the top plates and lower ends connected to upper ends of the paired piezoelectric vibrators, respectively.

## Patentansprüche

1. Längs-Teilezufuhrvorrichtung (21; 47), die eine Grundplatte (22; 48) und eine Mehrzahl von oberen Platten (23a, 23b; 59a, 59b, 59c) umfasst, die über ein Schwingungserregungsmittel (100) mit einer Oberseite der Grundplatte (22; 48) verbunden sind, und bei der die oberen Platten (23a, 23b; 59a, 59b, 59c) durch das Schwingungserregungsmittel (100) derart in Schwingung versetzt werden, dass Objekte transportiert werden, **dadurch gekennzeichnet, dass** das Schwingungserregungsmittel (100) ein Paar piezoelektrische Schwingungserzeuger (24a, 24b; 49a, 49b), die an der Grundplatte (22; 48) befestigt sind, und eine Mehrzahl von Paaren von Federelementen (25a - 25d; 58a - 58f) umfasst, die jeweils ein oberes Ende aufweisen, das mit beiden Enden der oberen Platten (23a, 23b; 59a, 59b, 59c) mit Bezug auf eine Transportrichtung jeder oberen Platte verbunden ist, und ein unteres Ende aufweisen, das mit oberen Enden der gepaarten piezoelektrischen Schwingungserzeuger (24a, 24b; 49a, 49b) verbunden ist.

2. Längs-Teilezufuhrvorrichtung nach Anspruch 1,
**dadurch gekennzeichnet, dass** die piezoelektrischen Schwingungserzeuger (24a, 24b; 49a, 49b) und die Federelemente (25a - 25d; 58a - 58f) jeweils über Abstandshalter (26a - 26d; 50a, 50b, 51a, 51b) miteinander verbunden sind.

3. Längs-Teilezufuhrvorrichtung nach Anspruch 2,
**dadurch gekennzeichnet, dass** die piezoelektrischen Schwingungserzeuger (24a, 24b; 49a, 49b) und die Federelemente (25a - 25d; 58a - 58f) derart angeordnet sind, dass sie im Wesentlichen senkrecht zu der Grundplatte (22; 48) stehen, und dass jeder Abstandshalter (26a - 26d; 50a, 50b, 51a, 51b) einen horizontalen Abstand zwischen jedem piezoelektrischen Schwingungserzeuger und dem entsprechenden Federelement definiert.

4. Längs-Teilezufuhrvorrichtung nach Anspruch 3,
**dadurch gekennzeichnet, dass** die Federelemente (25a - 25d; 58a - 58f), die mit einer oder mehreren der oberen Platten (23a, 23b; 59a, 59b, 59c) verbunden sind, über die Abstandshalter (26a - 26d; 50a, 50b, 51a, 51b) mit einer von beiden Seiten jedes piezoelektrischen Schwingungserzeugers (24a, 24b; 49a, 49b) verbunden sind, und die Federelemente (25a - 25d; 58a - 58f), die mit der anderen oberen Platte oder den anderen oberen Platten (23a, 23b; 59a, 59b, 59c) verbunden sind, über die Abstandshalter (26a - 26d; 50a, 50b, 51a, 51b) mit der anderen Seite jedes piezoelektrischen Schwingungserzeugers (24a, 24b; 49a, 49b) verbunden sind.

5. Längs-Teilezufuhrvorrichtung nach Anspruch 1,
**dadurch gekennzeichnet, dass** das Schwingungserregungsmittel (100) derart aufgebaut ist, dass eine Transportrichtung von einer oder mehreren der oberen Platten (23a, 23b; 59a, 59b, 59c) sich von einer Transportrichtung der anderen oberen Platte unterscheidet.

6. Längs-Teilezufuhrvorrichtung (21, 47), die eine Grundplatte (22; 48) und eine Mehrzahl von oberen Platten (23a, 23b; 59a, 59b, 59c) umfasst, die über ein Schwingungserregungsmittel (100) mit einer oberen Seite der Grundplatte (23; 48) verbunden sind, und bei der die oberen Platten (23a, 23b; 59a, 59b, 59c) durch das Schwingungserregungsmittel (100) derart in Schwingung versetzt werden, dass Artikel transportiert werden, **dadurch gekennzeichnet, dass** das Schwingungserregungsmittel (100) ein Paar elastische Platten umfasst, die an der Grundplatte (22; 48) befestigt sind, piezoelektrische Elemente, die an beiden Seiten von zumindest einer der gepaarten elastischen Platten angefügt sind, und eine Mehrzahl von Paaren von Federelementen (25a - 25d; 58a - 58f), die jeweils obere Enden aufweisen, die mit beiden Enden der oberen Platten mit Bezug auf eine Transportrichtung der oberen Platten verbunden sind, und untere Enden, die mit oberen Enden der gepaarten piezoelektrischen Schwingungserzeuger verbunden sind.

## Revendications

1. Dispositif d'alimentation de pièces en ligne (21 ; 47) comprenant une plaque de base (22 ; 48) et une pluralité de plaques supérieures (23a, 23b ; 59a, 59b, 59c) connectées par un moyen d'excitation par vibrations (100) à une face supérieure de la plaque de base (22 ; 48) et dans lequel les plaques supérieures (23a, 23b ; 59a, 59b, 59c) sont mises en vibration par le moyen d'excitation par vibrations (100) de sorte que des objets sont transportés, **caractérisé en ce que** le moyen d'excitation par vibrations (100) comprend une paire de vibreurs piézoélectriques (24a, 24b ; 49a, 49b) fixés à la plaque de base (22 ; 48) et une pluralité de paires d'éléments formant ressorts (25a-25d ; 58a-58f) ayant chacun une extrémité supérieure connectée aux deux extrémités des plaques supérieures (23a, 23b ; 59a, 59b, 59c) par rapport à une direction de transport de chaque plaque supérieure et une extrémité inférieure connectée aux extrémités supérieures des vibreurs piézoélectriques jumelés (24a, 24b ; 49a, 49b).

2. Dispositif d'alimentation de pièces en ligne selon la revendication 1, **caractérisé en ce que** les vibreurs piézoélectriques (24a, 24b ; 49a, 49b) et les éléments formant ressorts (25a-25d ; 58a-58f) sont connectés par l'intermédiaire d'entretoises (26a-26d ; 50a, 50b, 51a, 51b) respectivement les uns aux autres.

3. Dispositif d'alimentation de pièces en ligne selon la revendication 2, **caractérisé en ce que** les vibreurs piézoélectriques (24a, 24b ; 49a, 49b) et les éléments formant ressorts (25a-25d ; 58a-58f) sont disposés de façon à être sensiblement perpendiculaires à la plaque de base (22 ; 48), et chaque entretoise (26a-26d ; 50a, 50b, 51a, 51b) définit un espace horizontal entre chaque vibreur piézoélectrique et l'élément formant ressort correspondant.

4. Dispositif d'alimentation de pièces en ligne selon la revendication 3, **caractérisé en ce que** les éléments formant ressorts (25a-25d ; 58a-58f) connectés à une ou plusieurs des plaques supérieures (23a, 23b ; 59a, 59b, 59c) sont connectés par l'intermédiaire des entretoises (26a-26d ; 50a, 50b, 51a, 51b) à l'un des deux côtés de chaque vibreur piézoélectrique (24a, 24b ; 49a, 49b), et les éléments formant ressorts (25a-25d ; 58a-58f) connectés à l'autre plaque supérieure ou autres plaques supérieures (23a, 23b ; 59a, 59b, 59c) sont connectés par l'intermédiaire des entretoises (26a-26d ; 50a, 50b, 51a, 51b) à l'autre côté de chaque vibreur piézoélectrique (24a, 24b ; 49a, 49b).

5. Dispositif d'alimentation de pièces en ligne selon la revendication 1, **caractérisé en ce que** le moyen d'excitation par vibrations (100) est construit de telle manière qu'une direction de transport de l'une ou plusieurs des plaques supérieures (23a, 23b ; 59a, 59b, 59c) diffère d'une direction de transport de l'autre plaque supérieure.

6. Dispositif d'alimentation de pièces en ligne (21 ; 47) comprenant une plaque de base (22 ; 48) et une pluralité de plaques supérieures (23a, 23b ; 59a, 59b, 59c) connectées par un moyen d'excitation par vibrations (100) à une face supérieure de la plaque de base (22 ; 48) et dans lequel les plaques supérieures (23a, 23b ; 59a, 59b, 59c) sont mises en vibration par le moyen d'excitation par vibrations (100) de sorte que des articles sont transportés, **caractérisé en ce que** le moyen d'excitation par vibrations (100) comprend une paire de plaques élastiques fixées à la plaque de base (22 ; 48), des éléments piézoélectriques reliés aux deux côtés d'au moins l'une des plaques élastiques jumelées, et une pluralité de paires d'éléments formant ressorts (25a-25d ; 58a-58f) ayant des extrémités supérieures connectées aux deux extrémités des plaques supérieures par rapport à une direction de transport des plaques supérieures et des extrémités inférieures connectées respectivement aux extrémités supérieures des vibreurs piézoélectriques jumelés.
